# EUROPEAN PATENT SPECIFICATION

(11) **EP 3 232 269 B1**
(45) Date of publication and mention of the grant of the patent: **15.05.2019**
(21) Application number: 14907950.1
(22) Date of filing: 10.12.2014
(51) Int. Cl.: G03F 7/004, G03F 7/029, G03F 7/031, G03F 7/032, G03F 7/033, G03F 7/038, G03F 7/039, G03F 7/16, G03F 7/20, G03F 7/32, G03F 7/40

(54) **LIQUID SOLDER RESIST COMPOSITION AND COVERED PRINTED WIRING BOARD**
FLÜSSIGE LÖTSTOPPLACKZUSAMMENSETZUNG UND ABGEDECKTE LEITERPLATTE
COMPOSITION DE RÉSERVE DE SOUDURE LIQUIDE ET CARTE DE CIRCUIT IMPRIMÉ REVÊTUE

(43) Date of publication of application: 18.10.2017
(73) Proprietor: Goo Chemical Co., Ltd., Uji-shi, Kyoto 611-0043 (JP)
(72) Inventor: HAMADA, Nobuhito, Uji-shi Kyoto 611-0043 (JP); SAKAI, Yoshio, Uji-shi Kyoto 611-0043 (JP); HIGUCHI, Michiya, Uji-shi Kyoto 611-0043 (JP); MIYAKE, Tokuzan, Uji-shi Kyoto 611-0043 (JP)
(74) Representative: Appelt, Christian W.
(86) International application number: PCT/JP2014/006159
(87) International publication number: WO 2016/092597

(56) References cited:
- WO-A1-2011/125820
- WO-A1-2013/141156
- JP-A- 2009 223 253
- JP-A- 2012 078 414
- JP-A- 2012 078 414
- JP-A- 2012 193 219
- JP-A- 2014 209 172
- US-A1- 2009 141 505
- US-A1- 2012 112 140

## Description

### Technical Field

Liquid solder resist compositions and covered-printed wiring boards are disclosed.

Specifically, a liquid solder resist composition having photocurability and a covered-printed wiring board including a solder resist layer formed with the liquid solder resist composition are disclosed.

### Background Art

In recent years, as a method for forming solder resist layers on printed wiring boards for consumer use and industrial use, a developable liquid solder resist composition with excellent resolution and dimensional accuracy has been widely used, instead of a screen printing method, in order to increase the density of wiring on the printed wiring board.

Additionally, in recent years, there is an increasing use of optical elements, such as light-emitting diodes, mounted directly on a printed wiring board covered with a solder resist layer, wherein the light-emitting diodes are often used for: backlights in liquid crystal displays for mobile terminals, personal computers, and televisions; and light sources for lighting devices. Furthermore, when titanium dioxide is contained in the solder resist layer on the printed wiring board mounted with optical elements, the solder resist layer is whitened and therefore light emitted from the optical elements is efficiently reflected at the solder resist layer (see JP2012-78414A).

However, in a process of curing the liquid solder resist composition under exposure to light, titanium dioxide contained in the liquid solder resist composition may cause difficulty in curing of the liquid solder resist composition due to titanium dioxide reflecting light. Especially when the liquid solder resist composition contains a large amount of titanium dioxide, it is difficult for the solder resist layer formed with the liquid solder resist composition to completely cure down to a deep part of the solder resist layer. If the deep part of the solder resist layer is not thoroughly cured, it is likely for defects to occur, such as lowered resolution in development, wrinkles on the solder resist layer caused by a difference in curing shrinkages of the deep part and a surface of the solder resist layer, and cracks on the solder resist layer when heated due to a partial stress caused by a difference in thermal expansion coefficients of the deep part and the surface of the solder resist layer.

As described above, a large amount of titanium dioxide may impair required functions, such as heat resistance of a coating film and stability, of the liquid solder resist composition. Especially when used for forming a white cured coating film, in order to suppress decrease in light reflectivity, the liquid solder resist composition is required to be less likely to change in color due to light (ultraviolet rays) and heat (heating for a long period of time).

### Summary of Invention

The present disclosure aims to provide a liquid solder resist composition which has excellent curability and high heat resistance and can be formed into a coating film less likely to change in color due to light and heat. The present disclosure aims to provide a covered-printed wiring board including a solder resist layer which has excellent curability and high heat resistance and is less likely to change in color due to light and heat.

The liquid solder resist composition according to one aspect of the present disclosure contains: a carboxyl group-containing resin; a photopolymerizable compound which contains one or more kinds of compounds selected from a group consisting of a photopolymerizable monomer and a photopolymerizable prepolymer; a photopolymerization initiator; an epoxy compound; and titanium dioxide. The carboxyl group-containing resin is obtained by polymerization of a monomer composition which contains: a carboxyl group-containing monomer represented by following formula (1); and a maleimide compound represented by following formula (2). The carboxyl group-containing resin does not contain a photopolymerizable functional group.

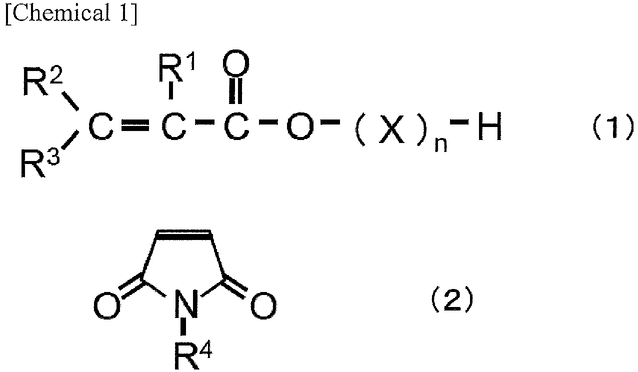

In the formula (1), R¹ represents a hydrogen atom or an alkyl group, R² represents a hydrogen atom, an alkyl group, or an aryl group, R³ represents a hydrogen atom, an alkyl group, or an aryl group, X represents R^{a}-COO, n represents a number which is 0 or larger, and R^{a} in the X represents an organic group. In the formula (2), R⁴ represents an organic group.

A covered-printed wiring board according to one aspect of the present disclosure includes: a printed wiring board; and a solder resist layer covering the printed wiring board. The solder resist layer is formed with the liquid solder resist composition.

The liquid solder resist composition according to the present disclosure has excellent curability and high heat resistance and can be formed into a coating film less likely to change in color due to light and heat.

The covered-printed wiring board according to the present disclosure includes a solder resist layer which has excellent curability and high heat resistance and is less likely to change in color due to light and heat.

### Description of Embodiments

A liquid solder resist composition according to the present disclosure contains: a carboxyl group-containing resin; a photopolymerizable compound which contains one or more kinds of compounds selected from a group consisting of a photopolymerizable monomer and a photopolymerizable prepolymer; a photopolymerization initiator; an epoxy compound; and titanium dioxide. The carboxyl group-containing resin is obtained by polymerization of a monomer composition which contains: a carboxyl group-containing monomer represented by following formula (1); and a maleimide compound represented by following formula (2). The carboxyl group-containing resin does not contain a photopolymerizable functional group.

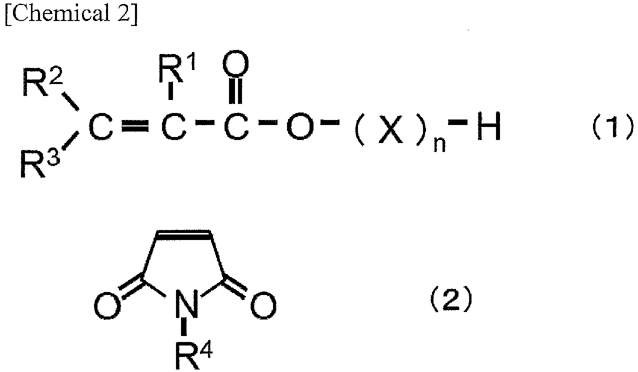

In the formula (1), R¹ represents a hydrogen atom or an alkyl group, R² represents a hydrogen atom, an alkyl group, or an aryl group, R³ represents a hydrogen atom, an alkyl group, or an aryl group, X represents R^{a}-COO, n represents a number which is 0 or larger, and R^{a} in the X represents an organic group. In the formula (2), R⁴ represents an organic group.

Since the liquid solder resist composition according to the present disclosure contains a polymer derived from a compound having a maleimide skeleton, heat resistance of a cured coating film of the liquid solder resist composition can be improved. Also, since the polymer is derived from the monomer represented by the formula (1) and the compound represented by the formula (2), a resist layer which has less occurrence of discoloration (especially yellowing) due to heat can be formed.

Note that the aforementioned components are hereinafter referred to as (A) carboxyl group-containing resin, (B) photopolymerizable compound, (C) photopolymerization initiator, (D) epoxy compound, and (E) titanium dioxide. The liquid solder resist composition may contain a component (referred to as "(F) other component") other than the (A), (B), (C), (D), and (E) components.

### (A) Carboxyl group-containing resin

The carboxyl group-containing resin is obtained by polymerization of the monomer composition.

The carboxyl group-containing resin can increase strength of the coating film formed with the liquid solder resist composition. The carboxyl group-containing resin can also increase heat resistance of the coating film formed with the liquid solder resist composition. The carboxyl group-containing resin can provide the coating film formed with the liquid solder resist composition with developability in an alkaline solution, i.e., alkaline developability.

The formula (1) represents the carboxyl group-containing monomer. In the formula (1), R¹ represents a hydrogen atom or an alkyl group. The alkyl group is preferably an alkyl group of 8 or less carbon atoms, more preferably an ethyl group or a methyl group, and further preferably a methyl group. When R¹ represents a hydrogen atom or a methyl group, the monomer represented by the formula (1) is a (meth)acrylic acid-based monomer.

Note that (meth)acryl is a generic name for acryl and methacryl. For example, (meth) acrylic acid is a generic name for acrylic acid and methacrylic acid. Therefore, "(meth)acryl" in the description hereinafter refers to at least one of acryl and methacryl.

In the formula (1), when n is 0, the monomer represented by the formula (1) does not have X.

In a case where n is 0, the monomer represented by the formula (1) gains COOH and thus has a carboxyl group. In this case, main examples of the monomer represented by the formula (1) include acrylic acid and methacrylic acid.

In the formula (1), when n is larger than 0, the monomer represented by the formula (1) has X. Considering the monomer macroscopically at a material level, n does not have to be an integer. Since the monomer as a material may contain compounds having various numbers of X (various numbers of n), n may take a number other than an integer. In this case, n means an average number of X. Considering the monomer microscopically at a single compound level, n takes an integer of 0 or larger. Considering the monomer represented by the formula (1) as a single compound, the single compound represented by the formula (1) has X when n is 1 or larger. In the formula (1), n is preferably less than or equal to 5, more preferably less than or equal to 4, and further preferably less than or equal to 3.

In the formula (1), X represents R^{a}-COO and thus the monomer represented by the formula (1) gains a carboxyl group. In a preferred embodiment, R^{a} is an alkylene group. When R^{a} is an alkylene group, the alkylene group is preferably of 8 or less carbon atoms. Also, when R^{a} is an alkylene group, the alkylene group is preferably of 2 or more carbon atoms. The monomer represented by the formula (1) may be a compound having a structure in which lactam is added to (meth)acrylic acid. Also, X in the formula (1) may be a compound having a structure which is derived from a dehydration reaction between dicarboxylic acid and diol.

In the formula (1), R² represents a hydrogen atom, an alkyl group, or an aryl group. The alkyl group is preferably an alkyl group of 8 or less carbon atoms, more preferably an ethyl group or a methyl group, and further preferably a methyl group. The aryl group is preferably an aryl group having one benzene ring, more preferably a phenyl group or a benzyl group, and further preferably a phenyl group. R² in the formula (1) is especially preferably a hydrogen atom.

In the formula (1), R³ represents a hydrogen atom, an alkyl group, or an aryl group. The alkyl group is preferably an alkyl group of 8 or less carbon atoms, more preferably an ethyl group or a methyl group, and further preferably a methyl group. The aryl group is preferably an aryl group having one benzene ring, more preferably a phenyl group or a benzyl group, and further preferably a phenyl group. R³ in the formula (1) is especially preferably a hydrogen atom.

The carboxyl group-containing monomer represented by the formula (1) has an ethylene-based unsaturated group. In this case, the monomer gains polymerizability. An ethylene-based unsaturated group is a double bond between two carbon atoms which can be polymerized. The carboxyl group-containing monomer represented by the formula (1) may have only one ethylene-based unsaturated group or may have two or more ethylene-based unsaturated groups. The carboxyl group-containing monomer represented by the formula (1) may contain one or more kinds of compounds selected from a group consisting of, for example, methacrylic acid, acrylic acid, ω-carboxy polycaprolactone monoacrylate, ω-carboxy polycaprolactone monomethacrylate, crotonic acid, cinnamic acid, phthalic acid monohydroxy ethyl acrylate, phthalic acid monohydroxy ethyl methacrylate, 2-acryloyloxyethyl succinic acid, 2-methacryloyloxyethyl succinic acid, 2-acryloyloxyethyl phthalic acid, 2-methacryloyloxyethyl phthalic acid, 2-acryloyloxyethyl maleic acid, 2-methacryloyloxyethyl maleic acid, 2-acryloyloxypropyl phthalic acid, β-carboxyethylacrylate, 2-acryloyloxyethyl tetrahydrophthalic acid, 2-methacryloyloxyethyl tetrahydrophthalic acid, 2-acryloyloxyethyl hexahydrophthalic acid, and 2-methacryloyloxyethyl hexahydrophthalic acid. These compounds may be used alone or in combination.

The carboxyl group-containing monomer represented by the formula (1) especially preferably contains one or more kinds of compounds selected from a group consisting of methacrylic acid, acrylic acid, ω-carboxy-polycaprolactone monomethacrylate, and ω-carboxy-polycaprolactone monoacrylate. The carboxyl group-containing monomer represented by the formula (1) further especially preferably contains: one or more kinds of compounds selected from a group consisting of methacrylic acid and acrylic acid; and one or more kinds of compounds selected from a group consisting of ω-carboxy-polycaprolactone monomethacrylate and eo-carboxy-polycaprolactone monoacrylate. The carboxyl group-containing monomer represented by the formula (1) further especially preferably contains: one or more kinds of compounds selected from a group consisting of methacrylic acid and acrylic acid; and ω-carboxy-polycaprolactone monoacrylate. The carboxyl group-containing monomer represented by the formula (1) further especially preferably contains methacrylic acid and ω-carboxy-polycaprolactone monoacrylate. When the liquid solder resist composition contains a polymer derived from these carboxylic acid-containing monomers, the pre-cured coating film formed with the liquid solder resist composition gains flexibility, and thermal reactivity between carboxyl groups and epoxy groups can be improved.

A chemical formula representing ω-carboxy-polycaprolactone monoacrylate is shown below.

[Chemical 3] CH₂=CHCOO-(C₅H₁₀COO)ₙ-H

In the above formula, n is a number of 0 or larger. Considering ω-carboxy-polycaprolactone monoacrylate microscopically at a single compound level, n takes an integer of 1 or larger. Considering ω-carboxy-polycaprolactone monoacrylate macroscopically at a material level, n may take a number other than integers. In this case, the number of repeating units may vary in the material. In this case, n is an average number of repeating units. It is preferable that n is larger than 1. It is preferable that n is less than 5. It is preferable that n is about 2. In such case, it is represented as n≒2. When n≒2, it means that n is larger than or equal to 1.5 and less than 2.4. It is preferable that ω-carboxy-polycaprolactone monoacrylate is co-carboxy-polycaprolactone (n≒2) monoacrylate.

The formula (2) represents the maleimide compound. In the formula (2), R⁴ represents an organic group. R⁴ may be an organic group of a relatively small molecular weight (for example, 200 or less). R⁴ is preferably a hydrocarbon group. The hydrocarbon group may be straight, branched, or cyclic, and may have an aromatic ring or a heterocycle. The hydrocarbon group may be saturated or unsaturated. R⁴ is preferably of 20 or less carbon atoms. R⁴ is preferably of 4 or more carbon atoms.

In a preferred embodiment, R⁴ in the formula (2) has an aromatic hydrocarbon group. In this case, R⁴ especially preferably includes a phenyl group. R⁴ itself may be a phenyl group, or R⁴ may be a functional group (phenyl alkyl group) in which a hydrogen atom of an alkyl group is substituted with a phenyl group.

In a preferred embodiment, R⁴ in the formula (2) has a cyclic saturated hydrocarbon group. In this case, R⁴ especially preferably includes a cyclohexyl group. R⁴ itself may be a cyclohexyl group, or R⁴ may be a functional group (cyclohexyl alkyl group) in which a hydrogen atom of an alkyl group is substituted with a cyclohexyl group.

The maleimide compound represented by the formula (2) may contain one or more kinds of compounds selected from a group consisting of, for example, N-benzyl maleimide, N-phenyl maleimide, and cyclohexyl maleimide. These maleimides may be used alone or in combination. When these maleimides are contained, the heat resistance is further improved.

The monomer composition used to form the carboxyl group-containing resin preferably contains a monomer, other than the carboxyl group-containing monomer and the maleimide compound. When the monomer other than the carboxyl group-containing monomer and the maleimide compound is contained, the coating film is further stabilized. In addition, basic properties of the coating film are easily improved. The monomer other than the carboxyl group-containing monomer and the maleimide compound is defined as an additional monomer.

The additional monomer can polymerize with the carboxyl group-containing monomer and the maleimide compound. The additional monomer preferably has an ethylene-based unsaturated group. The additional monomer may be an ethylene-based unsaturated monomer.

The additional monomer may be a compound which does not have a carboxyl group. The additional monomer may be a compound which does not contain a nitrogen element (N). The additional monomer may contain either one of an aromatic ring-containing compound and an aromatic ring-free compound.

The aromatic ring-containing compound may contain one or more kinds of compounds selected from a group consisting of, for example, 2-(meth)acryloyloxyethyl-2-hydroxyethyl phthalate, benzyl (meth)acrylate, neopentyl glycol benzoate (meth)acrylate, paracumyl phenoxyethylene glycol (meth)acrylate, EO-modified cresol (meth)acrylate, ethoxylated phenyl (meth)acrylate, nonylphenoxy polyethylene glycol (meth)acrylate (n=2-17), ECH-modified phenoxy (meth)acrylate, phenoxy diethylene glycol (meth)acrylate, phenoxyethyl (meth)acrylate, phenoxy hexaethylene glycol (meth)acrylate, phenoxy tetraethylene glycol (meth)acrylate, tribromophenyl (meth)acrylate, EO-modified tribromophenyl (meth)acrylate, EO-modified bisphenol A di(meth)acrylate, PO-modified bisphenol A di(meth)acrylate, modified bisphenol A di(meth)acrylate, EO-modified bisphenol F di(meth)acrylate, ECH-modified phthalic acid di(meth)acrylate, trimethylolpropane benzoate (meth)acrylate, EO-modified phthalic acid (meth)acrylate, EO/PO-modified phthalic acid (meth)acrylate, N-vinylcarbazole, styrene, vinylnaphthalene, and 4-vinylbiphenyl.

The aromatic ring-free compound may contain one or more kinds of compounds selected from a group consisting of, for example, straight or branched aliphatic (meth)acrylic acid esters or alicyclic (meth)acrylic acid esters (which may contain unsaturated bonding partially in a carbon ring), hydroxyalkyl (meth)acrylates, and alkoxyalkyl (meth)acrylates. Specific examples of the aromatic ring-free compound may include methyl methacrylate and t-butyl methacrylate. The aromatic ring-free compound may further contain a compound which has two or more ethylene-based unsaturated groups per molecule, such as polyethylene glycol di(meth)acrylate, polypropylene glycol di(meth)acrylate, trimethylolpropane tri(meth)acrylate, and pentaerythritol tri(meth)acrylate. These compounds may be used alone or in combination. These compounds are preferred since hardness and oiliness of the solder resist layer can be easily adjusted.

The additional monomer may contain the aromatic ring-containing compound only or may contain the aromatic ring-free compound only. However, the additional monomer preferably contains both of the aromatic ring-containing compound and the aromatic ring-free compound.

The additional monomer preferably contains one or more kinds of compounds selected from a group consisting of methyl (meth)acrylate, t-butyl (meth)acrylate, and styrene. The additional monomer preferably contains all three monomers of methyl (meth)acrylate, t-butyl (meth)acrylate, and styrene. The additional monomer preferably contains one or more kinds of compounds selected from a group consisting of methyl methacrylate, t-butyl methacrylate, and styrene. The additional monomer preferably contains all three monomers of methyl methacrylate, t-butyl methacrylate, and styrene.

The monomer composition preferably contains a solvent. In this case, monomers in the monomer composition can be easily polymerized. The solvent preferably contains an organic solvent. The organic solvent is used for polymerization of the monomer composition. The organic solvent may contain one or more kinds of compounds selected from a group consisting of: for example, ketones such as methyl ethyl ketone and cyclohexanone; aromatic hydrocarbons such as toluene and xylene; acetic acid esters such as ethyl acetate, butyl acetate, cellosolve acetate, butyl cellosolve acetate, butyl carbitol acetate, and propylene glycol monomethylether acetate; and dialkyl glycol ethers. For example, dipropylene glycol monomethylether may be used as the organic solvent.

The monomer composition preferably contains a polymerization initiator. In this case, the monomers in the monomer composition can be easily polymerized. The polymerization initiator may be a photopolymerization initiator. The polymerization initiator is used for polymerization of the monomer composition. The polymerization initiator may contain one or more kinds of compounds selected from a group consisting of, for example, hydroperoxides such as diisopropylbenzene hydroperoxide, dialkyl peroxides such as dicumyl peroxide and 2,5-dimethyl-2,5-di-(t-butylperoxy)-hexane, diacyl peroxides such as isobutyryl peroxide, ketone peroxides such as methyl ethyl ketone peroxide, alkyl peresters such as t-butyl peroxypivalate, peroxydicarbonates such as diisopropyl peroxydicarbonate, azo compounds such as azobisisobutyronitrile, and redox type initiators.

As explained above, the monomer composition preferably contains the carboxyl group-containing monomer represented by the formula (1), the maleimide compound represented by the formula (2), the polymerization initiator, and the organic solvent. The monomer composition may contain a component other than the above named components.

The monomer composition preferably contains 1 to 30 weight% of the maleimide compound represented by the formula (2) with respect to a total monomer content of the monomer composition. The heat resistance can be easily improved with an amount of the maleimide compound within this range. The total monomer content means a total amount of the monomers which polymerize in the monomer composition. The monomer content does not include amounts of the polymerization initiator and the organic solvent. The monomer content includes amounts of the carboxyl group-containing monomer represented by the formula (1), the maleimide compound represented by the formula (2), and the additional monomer. The monomer composition more preferably contains 3 to 25 weight% of the maleimide compound represented by the formula (2) with respect to the total monomer content. The monomer composition may contain larger than or equal to 5 weight% of the maleimide compound represented by the formula (2) with respect to the total monomer content. The monomer composition may contain less than or equal to 20 weight% of the maleimide compound represented by the formula (2) or may contain less than or equal to 15 weight% of the maleimide compound represented by the formula (2), with respect to the total monomer content.

The monomer composition preferably contains 10 to 50 weight% of the carboxyl group-containing monomer represented by the formula (1) with respect to the total monomer content. The heat resistance can be easily improved with an amount of the carboxyl group-containing monomer within this range. The monomer composition more preferably contains 20 to 40 weight% of the carboxyl group-containing monomer represented by the formula (1) with respect to the total monomer content. The monomer composition may contain larger than or equal to 25 weight% of the carboxyl group-containing monomer represented by the formula (1) with respect to the total monomer content. The monomer composition may contain less than or equal to 35 weight% of the carboxyl group-containing monomer represented by the formula (1) with respect to the total monomer content. Note that an amount of the additional monomer with respect to the total monomer content may be a value obtained by subtracting the amount of the carboxyl group-containing monomer represented by the formula (1) and the amount of the maleimide compound represented by the formula (2) from the total monomer content.

By the way, using the polymer derived from the carboxyl group-containing monomer represented by the formula (1) and the maleimide compound represented by the formula (2) makes it possible to obtain the liquid solder resist layer excellent in curability without undergoing a step of adding an unsaturated group to an acrylic resin. A catalyst is generally used in the step of adding an unsaturated group to an acrylic resin. However, the catalyst may cause color change. Since the coating film can gain good properties just by using the carboxyl group-containing monomer represented by the formula (1) and the maleimide compound represented by the formula (2), an unsaturated group does not need to be introduced and thus the catalyst is not required. In addition, an unsaturated group not being introducing improves resistance to yellowing, leading to prevention of discoloration.

The carboxyl group-containing resin is a polymerization product of the monomer composition. Ethylene-based unsaturated compounds in the monomer composition are polymerized to obtain polymers by a known polymerization method such as, for example, solution polymerization and emulsion polymerization. Examples of the solution polymerization include: a method in which the ethylene-based unsaturated compounds are heated and stirred in presence of a polymerization initiator in an appropriate organic solvent under a nitrogen atmosphere; and azeotropic polymerization.

The carboxyl group-containing resin contains a polymer of the monomer composition. The carboxyl group-containing resin may be in a form of liquid (a solution or dispersion) in which the polymer is dissolved or dispersed. The liquid carboxyl group-containing resin is defined as a carboxyl group-containing resin solution. The carboxyl group-containing resin solution contains the polymer and a solvent. The polymer may be dissolved or dispersed in the organic solvent. The organic solvent used to polymerize the monomers in the monomer composition can be used to dissolve or disperse the polymer. The organic solvent of the monomer composition may function also as the organic solvent of the carboxyl group-containing resin solution.

The carboxyl group-containing resin does not contain a photopolymerizable functional group. The polymer in the carboxyl group-containing resin is not photopolymerizable. Due to this, an effect of preventing discoloration of the coating film is improved. A photopolymerizable functional group means an ethylene-based unsaturated group. The carboxyl group-containing resin does not contain an ethylene-based unsaturated group. The polymer in the carboxyl group-containing resin does not contain an ethylene-based unsaturated group. In a preferred embodiment, the carboxyl group-containing resin contains only a compound which has a carboxyl group and is not photopolymerizable as the polymer. In this case, the heat resistance can be more easily improved and yellowing is more easily prevented. When the carboxyl group-containing resin as a whole does not have photopolymerizability, it becomes easier to improve the heat resistance and prevent yellowing.

The carboxyl group-containing resin has an acid value preferably within a range of 100 to 150 mgKOH/g. In this case, the basic properties of the coating film can be improved. Also, the heat resistance of the coating film can be improved. The carboxyl group-containing resin has the acid value more preferably larger than or equal to 110 mgKOH/g. The carboxyl group-containing resin may have the acid value larger than or equal to 120 mgKOH/g or larger than or equal to 130 mgKOH/g. The carboxyl group-containing resin may have the acid value less than or equal to 145 mgKOH/g or less than or equal to 140 mgKOH/g.

### (B) Photopolymerizable compound

The photopolymerizable compound provides photocurability to the liquid solder resist composition. The photopolymerizable compound contains one or more kinds of compounds selected from a group consisting of a photopolymerizable monomer and a photopolymerizable prepolymer.

The photopolymerizable monomer has, for example, an ethylene-based unsaturated group. The photopolymerizable monomer may contain monomers explained as the additional monomer of the aforementioned monomer composition. The photopolymerizable monomer may contain the carboxyl group-containing monomer represented by the formula (1), the maleimide compound represented by the formula (2), a carboxyl group-containing monomer other than the carboxyl group-containing monomer represented by the formula (1), and a maleimide compound other than the maleimide compound represented by the formula (2).

The photopolymerizable monomer preferably contains: dipentaerythritol penta and hexa acrylate (DPHA); and modified DPHA.

Also, the photopolymerizable monomer may contain one or more kinds of compounds selected from a group consisting of: for example, monofunctional (meth)acrylates such as 2-hydroxyethyl (meth)acrylate; and polyfunctional (meth)acrylates such as diethylene glycol di(meth)acrylate, trimethylolpropane di(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, and ε-caprolactone-modified pentaerythritol hexaacrylate.

The photopolymerizable monomer preferably contains a phosphorus-containing compound (a phosphorus-containing photopolymerizable compound). In this case, flame retardancy of a cured product of the liquid solder resist composition is improved. The phosphorus-containing photopolymerizable compound may contain one or more kinds of compounds selected from a group consisting of, for example, 2-methacryloyloxy ethyl acid phosphate (for example, Light Ester P-1M and Light Ester P-2M manufactured by Kyoeisha Chemical Co., Ltd.), 2-acryloyloxy ethyl acid phosphate (for example, Light Acrylate P-1A manufactured by Kyoeisha Chemical Co., Ltd.), diphenyl-2-methacryloyloxy ethyl phosphate (for example, MR-260 manufactured by Daihachi Chemical Industry Co., Ltd.), and HFA series manufactured by Showa Highpolymer K. K. (for example, HFA-6003 and HFA-6007 which are products of an addition reaction of dipentaerythritol hexaacrylate and HCA, and HFA-3003 and HFA 6127 which are products of an addition reaction of caprolactone-modified dipentaerythritol hexaacrylate and HCA).

Examples of the photopolymerizable prepolymer may include a prepolymer obtained by polymerization of photopolymerizable monomers. The photopolymerizable prepolymer preferably has one or more ethylene-based unsaturated groups. Other examples of the photopolymerizable prepolymer may include oligo (meth)acrylate prepolymers such as polyester (meth)acrylates, epoxy (meth)acrylates, urethane (meth)acrylates, alkyd resin (meth)acrylates, silicone resin (meth)acrylates, and spiran resin (meth)acrylates.

### (C) Photopolymerization initiator

The photopolymerization initiator can initiate polymerization of the above explained photopolymerizable compound promptly. Examples of the photopolymerization initiator include acylphosphine oxide-based photopolymerization initiators, alkyl phenone-based photopolymerization initiators, titanocene-based photopolymerization initiators, oxime ester-based photopolymerization initiators, and cation-based photopolymerization initiators. The photopolymerization initiator preferably contains one or more kinds of compounds selected from a group consisting of an acylphosphine oxide-based photopolymerization initiator, and an alkyl phenone-based photopolymerization initiator. The acylphosphine oxide-based photopolymerization initiator preferably contains a bisacylphosphine oxide-based photopolymerization initiator. The alkyl phenone-based photopolymerization initiator preferably contains an α-hydroxy alkylphenone-based photopolymerization initiator. The photopolymerization initiator further preferably contains both of the acylphosphine oxide-based photopolymerization initiator and the alkyl phenone-based photopolymerization initiator.

The photopolymerization initiator preferably contains the acylphosphine oxide-based photopolymerization initiator and the α-hydroxy alkylphenone-based photopolymerization initiator. In this case, the liquid solder resist composition excellent in curability can be obtained. The photopolymerization initiator further preferably contains the bisacylphosphine oxide-based photopolymerization initiator and the α-hydroxy alkylphenone-based photopolymerization initiator. Note that the α-hydroxy alkylphenone-based photopolymerization initiator contains at least one of α-hydroxy alkylphenone and an alkyl ester of α-hydroxy alkylphenone.

Further, the α-hydroxy alkylphenone-based photopolymerization initiator preferably contains an α-hydroxy alkylphenone-based photopolymerization initiator which is in a form of liquid at 25 °C and an α-hydroxy alkylphenone-based photopolymerization initiator which is in a form of solid at 25 °C. In this case, the curability and stability can be improved. The α-hydroxy alkylphenone-based photopolymerization initiator which is in a form of liquid at 25 °C is defined as a first α-hydroxy alkylphenone-based photopolymerization initiator. The α-hydroxy alkylphenone-based photopolymerization initiator which is in a form of solid at 25 °C is defined as a second α-hydroxy alkylphenone-based photopolymerization initiator.

By using the α-hydroxy alkylphenone-based photopolymerization initiator which is in a form of liquid at 25 °C and the α-hydroxy alkylphenone-based photopolymerization initiator which is in a form of solid at 25 °C in combination, the solder resist layer formed with the liquid solder resist composition can be thoroughly cured from a surface to a deep part. The aforementioned two kinds of the α-hydroxy alkylphenone-based photopolymerization initiators are especially preferably used with the bisacylphosphine oxide-based photopolymerization initiator. The reason for this is considered as following.

The bisacylphosphine oxide-based photopolymerization initiator can also react to a comparatively long-wavelength component of ultraviolet rays. Such comparatively long-wavelength component is likely to reach the deep part of the coating film made of the liquid solder resist composition. Therefore, the bisacylphosphine oxide-based photopolymerization initiator can improve the efficiency of a photocuring reaction in the deep part of the coating film.

On the other hand, the α-hydroxy alkylphenone-based photopolymerization initiator reacts to a comparatively short-wavelength component of ultraviolet rays. Such comparatively short-wavelength component is less likely to reach the deep part of the coating film. However, the α-hydroxy alkylphenone-based photopolymerization initiator is unlikely to be interfered by oxygen, and therefore has high photoreactivity. Due to this, the α-hydroxyalkyl phenone-based photopolymerization initiator can improve the efficiency of a photocuring reaction at the surface of the coating film. Since there exists a difference between a wavelength region of light to which the first α-hydroxy alkylphenone-based photopolymerization initiator reacts and a wavelength region of light to which the second α-hydroxy alkylphenone-based photopolymerization initiator reacts, ultraviolet rays can be efficiently used. Therefore, the photocuring reaction at the surface of the coating film proceeds further efficiently.

In the liquid solder resist composition, the photocuring reaction proceeds efficiently from the surface to the deep part of the coating film. Therefore, it is considered that the surface of the solder resist layer can be cured thoroughly and that at the same time the deep part of the solder resist layer also can be cured thoroughly.

If the solder resist layer is thoroughly cured from its surface to its deep part, the degree of curing of the solder resist layer tends not to be uneven, leading to less occurrence of wrinkles caused by shrinkage during curing. Accordingly, the solder resist layer has improved smoothness.

In addition, if the solder resist layer is thoroughly cured from the surface to the deep part, the solder resist layer can have high homogeneity. Due to this, even when the solder resist layer is deformed due to heat during steps such as soldering and reflow and thus experiences stress, such stress tends to be distributed throughout the solder resist layer, leading to less occurrence of cracks.

Moreover, since the bisacylphosphine oxide-based photopolymerization initiator is generally likely to be crystalized, if crystals of the bisacylphosphine oxide-based photopolymerization initiator are precipitated in the liquid solder resist composition, it becomes difficult for the liquid solder resist composition to be uniformly cured using ultraviolet rays. However, since the liquid solder resist composition contains the first α-hydroxyalkyl phenone-based photopolymerization initiator which is in a form of liquid at 25 °C, the crystals of the bisacylphosphine oxide-based photopolymerization initiator are prevented from being precipitated even when the liquid solder resist composition is stored for a long period of time. Accordingly, the liquid solder resist composition has improved storage stability.

Also, when the photopolymerization initiator contains the second α-hydroxyalkyl phenone-based photopolymerization initiator which is in a form of solid at 25 °C in addition to the bisacylphosphine oxide-based photopolymerization initiator and the first α-hydroxyalkyl phenone-based photopolymerization initiator, tackiness of the coating film is reduced. Due to this, handleability of the coating film is improved. In addition, even when a negative mask is disposed on the coating film while exposing light to the coating film, the negative mask is less likely to be adhered to the coating film, leading to improved workability.

Also, the α-hydroxyalkyl phenone-based photopolymerization initiator does not generate a benzyl radical during the photocuring reaction, and therefore the solder resist layer is unlikely to be colored. Furthermore, although the bisacylphosphine oxide-based photopolymerization initiator naturally has a color, bleaching occurs due to decomposition during the photocuring reaction, as a result of which the solder resist layer is unlikely to be colored. Thus, the solder resist layer is prevented from turning yellow, whiteness of the solder resist layer is increased, and good light reflectivity of the solder resist layer can be ensured.

The acylphosphine oxide-based photopolymerization initiators are classified into monoacylphosphine oxide-based photopolymerization initiators and bisacylphosphine oxide-based photopolymerization initiators.

The monoacylphosphine oxide-based photopolymerization initiator may contain one or more kinds of compounds selected from a group consisting of, for example, 2,4,6-trimethylbenzoyl-diphenyl-phosphine oxide (for example, IRGACURE TPO), and 2,4,6-trimethylbenzoyl-ethyl-phenyl-phosphinate (for example, SPEEDCURE TPO-L),

The bisacylphosphine oxide-based photopolymerization initiator may contain one or more kinds of compounds selected from a group consisting of, for example, bis-(2,6-dichlorobenzoyl)phenylphosphine oxide, bis-(2,6-dichlorobenzoyl)-2,5-dimethylphenyl phosphine oxide, bis-(2,6-dichlorobenzoyl)-4-propylphenylphosphine oxide, bis-(2,6-dichlorobenzoyl)-1-naphthylphosphine oxide, bis-(2,6-dimethoxybenzoyl)phenylphosphine oxide, bis-(2,6-dimethoxybenzoyl)-2,4,4-trimethylpentylphosphine oxide, bis-(2,6-dimethoxybenzoyl)-2,5-dimethylphenylphosphine oxide, bis-(2,4,6-trimethylbenzoyl)phenylphosphine oxide, and (2,5,6-trimethylbenzoyl)-2,4,4-trimethylpentylphosphine oxide. In particular, the bisacylphosphine oxide-based photopolymerization initiator preferably contains bis-(2,4,6-trimethylbenzoyl)phenylphosphine oxide, and more preferably contains only bis-(2,4,6-trimethylbenzoyl)phenylphosphine oxide. In these cases, the solder resist layer is further inhibited from being colored.

A melting point of the first α-hydroxy alkylphenone-based photopolymerization initiator is especially preferably within a range of -40 to 25°C. The first α-hydroxyalkyl phenone-based photopolymerization initiator may contain at least one of, for example, 2-hydroxy-2-methyl-1-phenyl-propane-1-one and phenylglyoxylic acid methyl ester. In particular, the first α-hydroxy alkylphenone-based photopolymerization initiator preferably contains 2-hydroxy-2-methyl-1-phenyl-propane-1-one, and also preferably contains only 2-hydroxy-2-methyl-1-phenyl-propane-1-one. In these cases, the solder resist layer is further inhibited from being colored.

A melting point of the second α-hydroxyalkyl phenone-based photopolymerization initiator is especially preferably within a range of 25 to 200°C. The second α-hydroxyalkyl phenone-based photopolymerization initiator may contain one or more kinds of compounds selected from a group consisting of 1-hydroxycyclohexyl phenyl ketone, 1-[4-(2-hydroxyethoxy)-phenyl]-2-hydroxy-2-methyl-1-propane-1-one, and 2-hydroxy-1-{4-[4-(2-hydroxy-2-methyl-propionyl)-benzyl]phenyl}-2-methyl-propane-1-one. In particular, the second α-hydroxy alkylphenone-based photopolymerization initiator preferably contains 1-hydroxycyclohexyl phenyl ketone, and also preferably contains only 1-hydroxycyclohexyl phenyl ketone. In these cases, the solder resist layer is further inhibited from being colored.

It is preferable that a mass ratio of the bisacylphosphine oxide-based photopolymerization initiator to the first α-hydroxy alkylphenone-based photopolymerization initiator is within a range of 1:0.5 to 1:5. If the mass ratio of the first α-hydroxy alkylphenone-based photopolymerization initiator relative to the bisacylphosphine oxide-based photopolymerization initiator is 0.5 or greater, the bisacylphosphine oxide-based photopolymerization initiator is particularly inhibited from being crystallized in the liquid solder resist composition, as a result of which the storage stability of the liquid solder resist composition is especially increased. Also, if the mass ratio of the first α-hydroxy alkylphenone-based photopolymerization initiator relative to the bisacylphosphine oxide-based photopolymerization initiator is 5 or less, the tackiness of the coating film (dry coating film) is especially reduced. It is further preferable that the mass ratio is within a range of 1:1 to 1:4.

It is preferable that a mass ratio of the bisacylphosphine oxide-based photopolymerization initiator to the second α-hydroxy alkylphenone-based photopolymerization initiator is within a range of 1:0.5 to 1:5. If the mass ratio of the second α-hydroxy alkylphenone-based photopolymerization initiator relative to the bisacylphosphine oxide-based photopolymerization initiator is 0.5 or greater, dissolution of the bisacylphosphine oxide-based photopolymerization initiator in the liquid solder resist composition is especially facilitated, as a result of which the storage stability of the liquid solder resist composition is especially increased. Also, if the mass ratio of the second α-hydroxyalkyl phenone-based photopolymerization initiator relative to the bisacylphosphine oxide-based photopolymerization initiator is 5 or less, the deep part of the solder resist layer gains especially high curability. It is further preferable that the mass ratio is within a range of 1:1 to 1:4.

The photopolymerization initiator preferably contains the acylphosphine oxide-based photopolymerization initiator and the α-hydroxy alkylphenone-based photopolymerization initiator only. However, the photopolymerization initiator may contain a photopolymerization initiator, in addition to or instead of the aforementioned kinds of photopolymerization initiators. For example, the photopolymerization initiator may contain, in addition to the aforementioned kinds of photopolymerization initiators, one or more kinds of compounds selected from a group consisting of: benzoins and alkylethers thereof; acetophenones such as acetophenone and benzyldimethyl ketal; anthraquinones such as 2-methylanthraquinone; thioxanthones such as 2,4-dimethylthioxanthone, 2,4-diethylthioxanthone, 2-isopropylthioxanthone, 4-isopropylthioxanthone, and 2,4-diisopropylthioxanthone; benzophenones such as benzophenone and 4-benzoyl-4'-methyldiphenylsulfide; xanthones such as 2,4-diisopropylxanthone; nitrogen atom-containing compounds such as 2-methyl-1-[4-(methylthio)phenyl]-2-morpholino-1-propanone; 1,2-octanedione; 1-[4-(phenylthio)-2-(O-benzoyloxyme)] (IRGACURE OXE 01); ethanone; and 1-[9-ethyl-6-(2-methylbenzoyl)-9H-carbazole-3-yl]-1-(O-acetyloxime) (IRGACURE OXE 02).

### (D) Epoxy compound

The epoxy compound can provide the liquid solder resist layer with thermosettability. The epoxy compound has a cyclic ether skeleton. The coating film with the high curability can be obtained by using the epoxy compound.

The epoxy compound preferably has at least two epoxy groups per molecule. The epoxy compound may be a hardly soluble epoxy compound and may be a generic soluble epoxy compound. Kinds of the epoxy compound are not particularly limited, but the epoxy compound especially preferably contains one or more kinds of compounds selected from a group consisting of phenol novolak epoxy resin (for example, EPICLON N-775 manufactured by DIC Corporation), cresol novolak epoxy resin (for example, EPICLON N-695 manufactured by DIC Corporation), bisphenol A epoxy resin (for example, jER1001 manufactured by Mitsubishi Chemical Corporation), bisphenol A-novolak epoxy resin (for example, EPICLON N-865 manufactured by DIC Corporation), bisphenol F epoxy resin (for example, jER4004P manufactured by Mitsubishi Chemical Corporation), bisphenol S epoxy resin (for example, EPICLON EXA-1514 manufactured by DIC Corporation), bisphenol AD epoxy resin, biphenyl epoxy resin (for example, YX4000 manufactured by Mitsubishi Chemical Corporation), biphenyl novolak epoxy resin (for example, NC-3000 manufactured by Nippon Kayaku Co., Ltd.), hydrogenated bisphenol A epoxy resin (for example, ST-4000D manufactured by Nippon Steel & Sumikin Chemical Co., Ltd.), naphthalene epoxy resin (for example, EPICLON HP-4032, EPICLON HP-4700, EPICLON HP-4770 manufactured by DIC Corporation), hydroquinone epoxy resin (for example, YDC-1312 manufactured by Nippon Steel & Sumikin Chemical Co., Ltd.), tertiary butylcatechol epoxy resin (for example, EPICLON HP-820 manufactured by DIC Corporation), dicyclopentadiene epoxy resin (for example, EPICLON HP-7200 manufactured by DIC Corporation), adamantane epoxy resin (for example, ADAMANTATE X-E-201 manufactured by Idemitsu Kosan Co., Ltd.), biphenylether epoxy resin (for example, YSLV-80DE manufactured by Nippon Steel & Sumikin Chemical Co., Ltd.), special two-functional epoxy resin (for example, YL7175-500 and YL7175-1000 manufactured by Mitsubishi Chemical Corporation; EPICLON TSR-960, EPICLON TER-601, EPICLON TSR-250-80BX, EPICLON 1650-75MPX, EPICLON EXA-4850, EPICLON EXA-4816, EPICLON EXA-4822, and EPICLON EXA-9726 manufactured by DIC Corporation; YSLV-120TE manufactured by Nippon Steel & Sumikin Chemical Co., Ltd.), and bisphenol epoxy resin excluding the above.

It is also preferable that the epoxy compound contains triglycidyl isocyanurate. The triglycidyl isocyanurate is especially preferably in a form of β isomers, in which three epoxy groups are located on the same side with respect to a flat s-triazine ring, or in a mixture of β isomers and α isomers, in which one epoxy group is located on the different side from other two epoxy groups with respect to a flat s-triazine ring.

The epoxy compound also preferably contains phosphorus-containing epoxy resin. In this case, the flame retardancy of the cured product of the liquid solder resist composition is improved. Examples of the phosphorus-containing epoxy resin may include phosphoric acid-modified bisphenol F epoxy resin (for example, EPICLON EXA-9726 and EPICLON EXA-9710 manufactured by DIC Corporation) and Epotohto FX-305 manufactured by Nippon Steel & Sumikin Chemical Co., Ltd.

### (E) Titanium dioxide

The titanium dioxide can whiten the coating film. Since the titanium dioxide colors the solder resist layer formed with the liquid solder resist composition white, the solder resist layer can gain the high light reflectivity. The titanium dioxide may contain either one or both of rutile titanium dioxide and anatase titanium dioxide. The titanium dioxide especially preferably contains the rutile titanium dioxide. The rutile titanium dioxide is manufactured either by a chlorine method or a sulfuric acid method. The rutile titanium dioxide may contain either one or both of the rutile titanium dioxide manufactured by the chlorine method and the rutile titanium dioxide manufactured by the sulfuric acid method.

### (F) Other component

The liquid solder resist composition may contain an organic solvent. The organic solvent makes it easier to apply the liquid solder resist layer.

The organic solvent in the liquid solder resist layer may contain the above explained organic solvent in the carboxyl group-containing resin solution. The organic solvent in the liquid solder resist layer may only contain the organic solvent in the carboxyl group-containing resin solution. The organic solvent in the liquid solder resist layer may contain an organic solvent in addition to the organic solvent in the carboxyl group-containing resin solution. The organic solvent is used to liquefy the liquid solder resist composition or form varnish with the liquid solder resist composition, and to adjust viscosity, applicability, and film-formability.

The organic solvent may contain one or more kinds of compounds selected from a group consisting of: for example, straight, branched, secondary, or poly alcohols such as ethanol, propyl alcohol, isopropyl alcohol, hexanol, and ethylene glycol; ketones such as methyl ethyl ketone and cyclohexanone; aromatic hydrocarbons such as toluene and xylene; petroleum aromatic mixed solvents such as Swazol series (manufactured by Maruzen Petrochemical Co., Ltd.) and Solvesso series (manufactured by Exxon Mobil Chemical Corporation); cellosolves such as cellosolve and butyl cellosolve; carbitols such as carbitol and butyl carbitol; propylene glycol alkyl ethers such as propylene glycol methyl ether; polypropylene glycol alkyl ethers such as dipropylene glycol methyl ether; acetic acid esters such as ethyl acetate, butyl acetate, cellosolve acetate, and carbitol acetate; and dialkyl glycol ethers.

An amount of the organic solvent in the liquid solder resist composition is preferably adjusted so that the organic solvent volatilizes quickly when a coating film formed with the liquid solder resist composition is dried, i.e. the organic solvent does not remain in the dry coating film. Especially, the amount of the organic solvent is preferably within a range of 0 to 99.5 weight% and further preferably within a range of 5 to 90 weight%, with respect to the total content of the liquid solder resist composition. Note that, since an appropriate amount of the organic solvent depends on a coating method, the amount is preferably adjusted appropriately depending on the coating method. If the liquid solder resist composition is in a form of liquid without the organic solvent, the liquid solder resist composition does not need to contain the organic solvent.

The liquid solder resist composition may contain components other than the above described components.

For example, the liquid solder resist composition may contain one or more kinds of resin selected from a group consisting of: blocked isocyanates of tolylene diisocyanate, morpholine diisocyanate, isophorone diisocyanate, and hexamethylene diisocyanate which are blocked with caprolactam, oxime, maleic acid ester, and the like; amino resin such as melamine resin, n-butylated melamine resin, isobutylated melamine resin, butylated urea resin, butylated melamine-urea co-condensed resin, and benzoguanamine-based co-condensed resin; various thermosetting resin other than the above; ultraviolet rays-curing epoxy (meth)acrylate; resin obtained by adding (meth)acrylic acid to epoxy resin such as bisphenol A epoxy resin, phenol novolak epoxy resin, cresol novolak epoxy resin, and alicyclic epoxy resin; and polymeric compounds such as diallyl phthalate resin, phenoxy resin, urethane resin, and fluorine resin.

The liquid solder resist composition may further contain a thermosetting component other than the epoxy compound.

The liquid solder resist composition may further contain a curing agent to cure the epoxy compound. The curing agent may contain one or more kinds of compounds selected from a group consisting of: for example, imidazole derivatives such as imidazole, 2-methylimidazole, 2-ethylimidazole, 2-ethyl-4-methylimidazole, 2-phenylimidazole, 4-phenylimidazole, 1-cyanoethyl-2-phenylimidazole, and 1-(2-cyanoethyl)-2-ethyl-4-methylimidazole; amine compounds such as dicyandiamide, benzyldimethylamine, 4-(dimethylamino)-N,N-dimethylbenzylamine, 4-methoxy-N,N-dimethylbenzylamine, and 4-methyl-N,N-dimethylbenzylamine; hydrazine compounds such as adipic acid hydrazide and sebacic acid hydrazide; phosphorus compounds such as triphenylphosphine; acid anhydrides; phenols; mercaptans; Lewis acid amine complexes; and onium salts. Examples of commercial products of the above compounds may include: 2MZ-A, 2MZ-OK, 2PHZ, 2P4BHZ, and 2P4MHZ manufacture by Shikoku Chemicals Corporation (product names for commercial products of imidazole compounds); U-CAT3503N and U-CAT3502T manufactured by San-Apro Ltd. (product names for commercial products of blocked isocyanates of dimethylamine); and DBU, DBN, U-CATSA102, and U-CAT5002 manufactured by San-Apro Ltd. (bicyclic amidine compounds and salts thereof).

The liquid solder resist composition may contain an adhesiveness-imparting agent. Examples of the adhesiveness-imparting agent may include: guanamine; acetoguanamine; benzoguanamine; melamine; and S-triazine derivatives such as 2,4-diamino-6-methacryloyloxyethyl-S-triazine, 2-vinyl-4,6-diamino-S-triazine, 2-vinyl-4,6-diamino-S-triazine-isocyanuric acid adduct, and 2,4-diamino-6-methacryloyloxyethyl-S-triazine-isocyanuric acid adduct.

The liquid solder resist composition may further contain a photopolymerization promotor and a sensitizer. The liquid solder resist composition may contain, for example, p-dimethylbenzoic acid ethylester, p-dimethylaminobenzoic acid isoamyl ester, and 2-dimethylaminoethyl benzoate.

The liquid solder resist composition may contain one or more kinds of compounds selected from a group consisting of: a curing promotor; a coloring agent other than white; a copolymer such as silicones and acrylates; a leveling agent; an adhesiveness-imparting agent such as silane coupling agents; a thixotropy agent; a polymerization inhibitor; a halation preventer; a flame retardant; a defoamer; an antioxidant; a surfactant; a polymer dispersant; and an inorganic filler such as barium sulfate, crystalline silica, nano silica, carbon nanotube, talc, bentonite, aluminum hydroxide, and magnesium hydroxide.

### Ratios of (A) to (F) components

An amount of each component in the liquid solder resist composition is appropriately adjusted so that the liquid solder resist composition has photocurability. An amount of each component in the liquid solder resist composition is appropriately adjusted so that the resist layer is developable with an alkaline solution.

An amount of (A) the carboxyl group-containing resin is preferably within a range of 5 to 85 weight%, more preferably within a range of 10 to 80 weight%, and further preferably within a range of 15 to 75 weight%, with respect to solid content of the liquid solder resist composition.

An amount of (B) the photopolymerizable compound is preferably within a range of 1 to 45 weight%, more preferably within a range of 2 to 40 weight%, and further preferably within a range of 3 to 35 weight%, with respect to the solid content of the liquid solder resist composition.

An amount of (C) the photopolymerization initiator is preferably within a range of 0.1 to 30 weight% and further preferably within a range of 0.2 to 20 weight%, with respect to the solid content of the liquid solder resist composition.

An amount of (D) the epoxy compound is preferably within a range of 1 to 65 weight%, more preferably within a range of 3 to 60 weight%, and further preferably within a range of 4 to 50 weight%, with respect to the solid content of the liquid solder resist composition.

An amount of (E) the titanium dioxide is preferably within a range of 1 to 500 weight% and further preferably within a range of 5 to 300 weight%, with respect to resin content of the liquid solder resist composition. Note that the resin content of the liquid solder resist composition is defined as a total amount of the polymers contained in the carboxyl group-containing resin, the photopolymerizable compound, and the thermosetting component included in the liquid solder resist composition.

### Preparation of liquid solder resist composition

Ingredients as described above for the liquid solder resist composition are combined and kneaded by a known kneading method using, for example, a three-roll, a ball mill, or a sand mill to obtain the liquid solder resist composition.

Considering the storage stability of the liquid solder resist composition, some of the ingredients of the liquid solder resist composition may be mixed to obtain an intermediate reagent, and the rest of the ingredients (additional reagent) may be mixed to the intermediate reagent to obtain the liquid solder resist composition (final product). That is, the liquid solder resist composition may include the intermediate reagent and the additional reagent. For example, the photopolymerizable compound, some of the organic solvents, and the thermosetting component out of all the ingredients may be mixed and dispersed in advance to obtain the intermediate reagent, and the rest of the ingredients may be mixed and dispersed in the intermediate reagent to obtain the liquid solder resist composition. In this case, appropriate amounts of the intermediate reagent and the additional reagent may be mixed to obtain a mixture which is used to form the solder resist layer.

### Use of liquid solder resist composition

The liquid solder resist composition is used, for example, to form a solder resist layer on a printed wiring board.

Described below is an example of a method to form a solder resist layer on a printed wiring board using the liquid solder resist composition. In this example, a solder resist layer is formed with the liquid solder resist composition which has the photocurability and the thermosettability.

First, a printed wiring board is prepared, and a coating film of the liquid solder resist composition is formed on the printed wiring board. For example, a surface of the printed wiring board is coated with the liquid solder resist composition to form the coating film in a wet state (wet coating film). A coating method to coat the printed wiring board with the liquid solder resist composition is selected from a group consisting of known methods such as, for example, a dipping method, a spray method, a spin coating method, a roll coating method, a curtain coating method, and a screen printing method. Subsequently, if necessary, in order for the organic solvent in the liquid solder resist composition to volatilize, the wet coating film is dried at a temperature, for example, within a range of 60 to 120 °C to obtain the coating film after drying (dry coating film).

Note that, in formation of the coating film on the printed wiring board, the liquid solder resist composition may be applied to an appropriate supporting body and dried to form the dry coating film in advance. The dry coating film may be then stacked on the printed wiring board, and pressure is applied to the dry coating film and the printed wiring board to form the dry coating film on the printed wiring board (a dry film method).

Subsequently, a negative mask is placed either directly or indirectly on the dry coating film on the printed wiring board and then the active energy rays are irradiated to the negative mask so that the coating film is exposed to light through the negative mask. The negative mask includes an exposed part, which transmits the active energy rays, and an unexposed part, which does not transmit the active energy rays. The exposed part of the negative mask has a shape corresponding to a pattern shape of the solder resist layer. For example, photo tools such as a mask film and a dry plate are used as the negative mask. A kind of active energy rays is selected depending on composition of the liquid solder resist composition, and ultraviolet rays are preferably used. A light source for ultraviolet rays is selected from a group consisting of, for example, a chemical lamp, a low pressure mercury lamp, a medium pressure mercury lamp, a high pressure mercury lamp, an ultra-high pressure mercury lamp, a xenon lamp, and a metal halide lamp.

Note that a method which does not use a negative mask may be employed as an exposure method. For example, a direct drawing method such as laser exposure may be employed.

When the dry coating film formed with the liquid solder resist composition is exposed to ultraviolet rays, the photocuring reaction proceeds efficiently in the dry coating film from its surface to its deep part, as described above.

After the dry coating film is exposed to light, the negative mask is removed from the printed wiring board and then the dry coating film undergoes a development process to remove the unexposed part of the dry coating film. Accordingly, the exposed part of the dry coating film remains as the solder resist layer on a surface of the printed wiring board.

In the development process, an appropriate developer depending on the composition of the liquid solder resist composition may be used. The liquid solder resist composition is developable with an alkaline solution. Examples of the developer may include alkaline solutions such as aqueous solutions of sodium carbonate, potassium carbonate, ammonium carbonate, sodium hydrogen carbonate, potassium hydrogen carbonate, ammonium hydrogen carbonate, sodium hydroxide, potassium hydroxide, ammonium hydroxide, tetramethylammonium hydroxide, and lithium hydroxide. Organic amines such as monoethanol amine, diethanol amine, triethanol amine, monoisopropanol amine, diisopropanol amine, and triisopropanol amine may be used as the developer. Above described developers may be used alone or in combination. When the developer is the alkaline solution, a solvent of the alkaline solution may be water alone or may be a mixture of water and a hydrophilic organic solvent such as lower alcohols.

When the liquid solder resist composition contains the thermosetting component, the solder resist layer may be thermosetted by heat treatment, if necessary. As for conditions of the heat treatment, for example, a heating temperature is within a range of 120 to 180 °C and a heating period is within a range of 30 to 90 minutes. Accordingly, properties of the solder resist layer, such as strength, hardness, and chemical resistance, are improved.

Furthermore, after the solder resist layer undergoes the heat treatment, the solder resist layer may be irradiated with ultraviolet rays again if necessary. In this case, the photocuring reaction further proceeds in the solder resist layer. Accordingly, migration resistance of the solder resist layer is further improved.

As a result, the covered-printed wiring board which includes the printed wiring board and the solder resist layer partially covering the printed wiring board is obtained. The solder resist layer may be white. The solder resist layer can maintain high whiteness.

As explained above, the covered-printed wiring board according to the present disclosure includes: the printed wiring board; and the solder resist layer covering the printed wiring board. The solder resist layer is formed with the liquid solder resist composition.

### (Examples)

Hereinafter, examples are described. Note that the liquid solder resist composition according to the present disclosure is not limited to following examples.

### [Preparations of carboxyl group-containing resin solutions]

Ingredients listed in the following Table 1 were added to a four-neck flask equipped with a reflux condenser, a thermometer, a glass tube for nitrogen-substitution, and a stirrer, at ratios as listed in Table 1. Note that dipropylene glycol monomethylether was used as the organic solvent and azobisisobutyronitrile was used as the polymerization initiator. As for ω-carboxy-polycaprolactone monoacrylate, ω-carboxyl-polycaprolactone (n≒2) monoacrylate was used. A mixture in the four-neck flask was heated at 80 °C for 5 hours under a nitrogen gas stream for a polymerization reaction to proceed, resulting in a copolymer solution. Accordingly, carboxyl group-containing resin solutions A-1 to A-14 were obtained. Note that the ratios of the ingredients in Table 1 are expressed in "parts by mass".

Resin solutions a-2 to a-4 for comparative examples were also obtained by the same operations as the carboxyl group-containing resin solutions A-1 to A-14.

### [Preparation of resin solution containing a carboxyl group and a photopolymerizable functional group]

A copolymer solution was prepared by the same operations as the carboxyl group-containing resin solutions A-1 to A-14 using ingredients listed in the following Table 1. Resin solution a-1 having photopolymerizability was obtained by adding 0.1 parts by mass of hydroquinone, 70 parts by mass of glycidyl methacrylate, and 4.0 parts by mass of dimethylbenzylamine to the copolymer solution and letting an addition reaction proceed at 80 °C for 24 hours.

### [Preparations of liquid solder resist compositions]

A mixture obtained by mixing components listed in the following Table 2A was kneaded using a three-roll to obtain a liquid solder resist composition. In Table 2A, A-1 to A-14 represent the carboxyl group-containing resin solutions A-1 to A-14 and a-1 to a-4 represent the resin solutions a-1 to a-4. Note that ratios of the components in Table 2A are expressed in "parts by mass".

Details of the components listed in Table 2A are as following.
*Photopolymerizable monomer (DPHA): dipentaerythritol penta and hexa acrylate (manufactured by Nippon Kayaku Co., Ltd.).
*Photopolymerization initiator (IRGACURE 819): bis-(2,4,6-trimethylbenzoyl)-phenylphosphine oxide, manufactured by BASF, item No. IRGACURE 819.
*Photopolymerization initiator (IRGACURE 184): 1-hydroxy-cyclohexyl-phenyl-ketone, manufactured by BASF, in a form of solid at 25 °C, item No. IRGACURE 184.
*Photopolymerization initiator (DAROCUR 1173): 2-hydroxy-2-methyl-1-phenyl-propane-1-one, manufactured by BASF, in a form of liquid at 25 °C, item No. DAROCUR 1173.
*Photopolymerization initiator (IRGACURE TPO): 2,4,6-trimethylbenzoyl-diphenyl-phosphine oxide, manufactured by BASF, item No. IRGACURE TPO.
*Epoxy compound: triglycidyl isocyanurate manufactured by NISSAN CHEMICAL INDUSTRIES, Ltd., item No. TEPIC-SP.
* Rutile titanium dioxide CR-90: rutile titanium dioxide manufactured by a chlorine method, manufactured by ISHIHARA SANGYO KAISHA, LTD., item No. CR-90.
*Rutile titanium dioxide R-79: rutile titanium dioxide manufactured by a sulfuric acid method, manufactured by SAKAI CHEMICAL INDUSTRY CO., LTD., item No. R-79.
*Melamine: manufactured by NISSAN CHEMICAL INDUSTRIES, Ltd., fine-particulate melamine.
*Defoamer (silicone): manufactured by Shin-Etsu Chemical Co., Ltd., item No. KS-66.

### [Evaluation tests]

### <Preparations of test pieces>

A glass epoxy copper-clad laminated plate including a copper foil with thickness of 35 µm was prepared. A conductor wiring was formed by etching on the glass epoxy copper-clad laminated plate to obtain a printed wiring board. A surface of the obtained printed wiring board was entirely coated with the liquid solder resist composition by a screen printing method and thereby a coating film was formed. The coating film was dried by heating at 80 °C for 20 minutes. Thickness of the coating film after drying (dry coating film) was 20 µm. With a negative mask placed directly on the dry coating film, the negative mask was irradiated with ultraviolet rays, and accordingly the dry coating film was selectively exposed to light with 450 mJ/cm² of exposure. Then, the negative mask was removed from the dry coating film, and the dry coating film was developed with a sodium carbonate aqueous solution so that a part of the dry coating film, which was cured due to exposure to light, remained as a solder resist layer on the printed wiring board. The solder resist layer was further heated at 150 °C for 60 minutes and thermosetted. As a result, a test piece including the solder resist layer was obtained.

Following evaluation tests were carried out for each test piece. The results of the evaluation tests are shown in the following Table 2B. Note that Table 2 includes Table 2A and Table 2B.

### <Acid resistance>

Each test piece was dipped in a 10% sulfuric acid solution at room temperature for 30 minutes and then pulled out. Succeedingly, the peeled state after a peeling test using the cellophane adhesive tape was visually observed to see whether there was change such as peeling and resist discoloration. The results were evaluated as follows.
A: No change in surface appearance was observed.
B: Slight change in surface appearance was observed.
C: Significant change in surface appearance was observed.

### <Alkali resistance>

Each test piece was dipped in a 10% aqueous sodium hydroxide solution at room temperature for 1 hour and then pulled out. Succeedingly, surface appearance of the solder resist layer of each test piece was visually observed to see whether there was change such as peeling. The results were evaluated as follows.
A: No change in surface appearance was observed.
B: Slight change in surface appearance was observed.
C: Significant change in surface appearance was observed.

### <Adhesion>

In accordance with a test method of JIS D0202, a cross-cut was made into the solder resist layer of each test piece, and then the peeled state after a peeling test using the cellophane adhesive tape was visually observed. The results were evaluated as follows.
A: There was no change in any of the 100 cross-cut portions.
B: There was a slight raise in one portion among the 100 cross-cut portions.
C: There was peeling in 2 to 10 portions among the 100 cross-cut portions.
D: There was peeling in 11 to 100 portions among the 100 cross-cut portions.

### <PCT (Pressure Cocker Test) property>

Each test piece was kept in saturated steam at 121 °C under pressure of 2 atm for 8 hours, and then the temperature and the pressure were decreased to normal temperature and normal pressure, respectively. After confirming that the temperature and the pressure were completely down to normal, each test piece was pulled out. Succeedingly, surface appearance of the solder resist layer of each test piece was visually observed to see whether there was change such as blistering, peeling, and resist discoloration. The results were evaluated as follows.
A: No change in surface appearance was observed.
B: Slight change in surface appearance was observed.
C: Significant change in surface appearance was observed.

### <Crack resistance>

Each test piece was cut off with a utility knife, and then peeling test was carried out on the solder resist layer close to a cut face using a cellophane adhesion tape. The solder resist layer after the peeling test was observed. The results were evaluated as follows.
A: No crack was observed in the solder resist layer, and the solder resist layer was not peeled off after peeling test using a cellophane adhesion tape.
B: Crack was observed in the solder resist layer, but the solder resist layer was not peeled off after peeling test using a cellophane adhesion tape.
C: Crack was observed in the solder resist layer, and the solder resist layer was peeled off after peeling test using a cellophane adhesion tape.

### <Solder heat resistance>

A flux was applied on each test piece using LONCO 3355-11 (a water-soluble flux manufactured by London Chemical Co., Inc.). Succeedingly, each test piece was dipped in a melted solder bath at 260 °C for 10 seconds and then rinsed with water. After the aforementioned process was carried out 3 times, surface appearance of the solder resist layer was observed. The results were evaluated as follows.
A: No change was observed in the solder resist layer.
B: Slight change was observed in the solder resist layer.
C: Significant change such as peeling was observed in the solder resist layer.

### <Pencil hardness>

The pencil hardness of the solder resist layer of each test piece was measured using a Mitsubishi Hi-uni pencil (manufactured by Mitsubishi Pencil Co., Ltd.) in accordance with JIS K5400.

### <Discoloration resistance due to ultraviolet rays (Δb* value)>

For the solder resist layer of each test piece, b* value in an L*a*b* colorimetric system was measured using a spectrophotometer (model number CM-600d) manufactured by Konica Minolta Sensing, Inc. Then, the solder resist layer of each test piece was irradiated with ultraviolet rays using a metal halide lamp under the condition of 20 J/cm², and b* value in an L*a*b* colorimetric system of the solder resist layer after ultraviolet irradiation treatment was measured again. A value (Δb*) was calculated by subtracting the b* value of the solder resist layer before the ultraviolet irradiation treatment from the b* value of the solder resist layer after the ultraviolet irradiation treatment. The results were evaluated as follows.
A: Δb* value was less than 1.5.
B: Δb* value was larger than or equal to 1.5 and less than 2.0.
C: Δb* value was larger than or equal to 2.0 and less than 2.5.
D: Δb* value was larger than or equal to 2.5.

### <Discoloration resistance due to heat (Δb* value)>

For the solder resist layer of each test piece, b* value in an L*a*b* colorimetric system was measured using a spectrophotometer (model number CM-600d) manufactured by Konica Minolta Sensing, Inc. Then, after the solder resist layer of each test piece underwent heat treatment at 250 °C for 2 minutes, b* value of the solder resist layer was measured again. A value (Δb*) was calculated by subtracting the b* value of the solder resist layer before the heat treatment from the b* value of the solder resist layer after the heat treatment. The results were evaluated as follows.
A: Δb* value was less than 1.5.
B: Δb* value was larger than or equal to 1.5 and less than 2.0.
C: Δb* value was larger than or equal to 2.0 and less than 2.5.
D: Δb* value was larger than or equal to 2.5.

### <Reflectivity>

For the solder resist layer of each test piece, Y value in an X, Y, Z colorimetric system was measured using a spectrophotometer (model number CM-600d) manufactured by Konica Minolta Sensing, Inc., and thereby reflectivity was calculated.

### <Results>

As shown in Table 2B, discoloration due to ultraviolet rays (yellowing) and discoloration due to heat (yellowing) occur less in the resist layers formed with the liquid solder resist compositions of the examples, in addition to high basic properties. Note that development defects occurred in the comparative examples 2 and 4 and thus some evaluations tests were not carried out.

**[Table 1]**

| (Unit: parts by mass) | | | | | | | | | | | | | | | | | | | |
|---|---|---|---|---|---|---|---|---|---|---|---|---|---|---|---|---|---|---|---|
| | | Synthetic examples of carboxyl group-containing resin solutions | | | | | | | | | | | | | | Synthetic examples of resin solutions | | | |
| | | A-1 | A-2 | A-3 | A-4 | A-5 | A-6 | A-7 | A-8 | A-9 | A-10 | A-11 | A-12 | A-13 | A-14 | a-1 | a-2 | a-3 | a-4 |
| Monomer | Methacrylic acid | 35 | 42 | 42 | 49 | 42 | 42 | 38 | 35 | 35 | 31 | 35 | 42 | 42 | 42 | 84 | | 42 | |
| | ω-carboxy-polycaprolactone monoacrylate | | | | | | | 10 | 20 | 20 | 30 | 20 | | | | | | | |
| | N-benzyl maleimide | | | | | 20 | | | | | | | | | | | | | |
| | N-phenyl maleimide | 20 | 20 | 20 | 20 | | | 20 | 20 | 20 | 20 | 10 | 30 | 30 | 40 | | 20 | | |
| | Cyclohexyl maleimide | | | | | | 20 | | | | | | | | | | | | |
| | Methyl methacrylate | 105 | 98 | 118 | 91 | 98 | 98 | 92 | 85 | 125 | 79 | 95 | 88 | 108 | 78 | 86 | 140 | 98 | 160 |
| | *t*-butyl methacrylate | 20 | 20 | 20 | 20 | 20 | 20 | 20 | 20 | | 20 | 20 | 20 | 20 | 20 | 30 | 20 | 20 | 20 |
| | Styrene | 20 | 20 | | 20 | 20 | 20 | 20 | 20 | | 20 | 20 | 20 | | 20 | | 20 | 40 | 20 |
| | Glycidyl methacrylate | | | | | | | | | | | | | | | 70 | | | |
| Polymerization initiator | | 14 | 14 | 14 | 14 | 14 | 14 | 14 | 14 | 14 | 14 | 14 | 14 | 14 | 14 | 14 | 14 | 14 | 14 |
| Organic solvent | | 300 | 300 | 300 | 300 | 300 | 300 | 300 | 300 | 300 | 300 | 300 | 300 | 300 | 300 | 300 | 300 | 300 | 300 |
| Acid value (mgKOH/g) | | 115 | 134 | 135 | 148 | 130 | 131 | 128 | 133 | 133 | 130 | 132 | 134 | 132 | 134 | 108 | 0 | 134 | 0 |

**[Table 2A]**

| | | | | Examples | | | | | | | | | | | | | | | | Comparative examples | | | | |
|---|---|---|---|---|---|---|---|---|---|---|---|---|---|---|---|---|---|---|---|---|---|---|---|---|
| | | | | 1 | 2 | 3 | 4 | 5 | 6 | 7 | 8 | 9 | 10 | 11 | 12 | 13 | 14 | 15 | 16 | 1 | 2 | 3 | 4 | 5 |
| | A | Carboxyl group-containing resin solution | A-1 | 80 | | | | | | | | | | | | | | | 80 | | | | | |
| | | | A-2 | | 80 | | | | | | | | | | | | | 80 | | | | | | |
| | | | A-3 | | | 80 | | | | | | | | | | | | | | | | | | |
| | | | A-4 | | | | 80 | | | | | | | | | | | | | | | | | |
| | | | A-5 | | | | | 80 | | | | | | | | | | | | | | | | |
| | | | A-6 | | | | | | 80 | | | | | | | | | | | | | | | |
| | | | A-7 | | | | | | | 80 | | | | | | | | | | | | | | |
| | | | A-8 | | | | | | | | 80 | | | | | | | | | | | | | |
| | | | A-9 | | | | | | | | | 80 | | | | | | | | | | | | |
| | | | A-10 | | | | | | | | | | 80 | | | | | | | | | | | |
| | | | A-11 | | | | | | | | | | | 80 | | | | | | | | | | |
| | | | A-12 | | | | | | | | | | | | 80 | | | | | | | | | |
| | | | A-13 | | | | | | | | | | | | | 80 | | | | | | | | |
| Composition/parts by mass | | | A-14 | | | | | | | | | | | | | | 80 | | | | | | | |
| | a | Resin solution | a-1 | | | | | | | | | | | | | | | | | 80 | | | | |
| | | | a-2 | | | | | | | | | | | | | | | | | | 80 | | | |
| | | | a-3 | | | | | | | | | | | | | | | | | | | 80 | | 80 |
| | | | a-4 | | | | | | | | | | | | | | | | | | | | 80 | |
| | B | DPHA | | 35 | 35 | 35 | 35 | 35 | 35 | 35 | 35 | 35 | 35 | 35 | 35 | 35 | 35 | 35 | 35 | 35 | 35 | 35 | 35 | 35 |
| | C | IRGACURE 819 | | 4 | 4 | 4 | 4 | 4 | 4 | 4 | 4 | 4 | 4 | 4 | 4 | 4 | 4 | 2 | 4 | 4 | 4 | 4 | 4 | 4 |
| | | IRGACURE 184 | | 2 | 2 | 2 | 2 | 2 | 2 | 2 | 2 | 2 | 2 | 2 | 2 | 2 | 2 | 2 | 2 | 2 | 2 | 2 | 2 | 2 |
| | | DAROCUR 1173 | | 10 | 10 | 10 | 10 | 10 | 10 | 10 | 10 | 10 | 10 | 10 | 10 | 10 | 10 | 2 | 10 | 10 | 10 | 10 | 10 | 2 |
| | | IRGACURE TPO | | | | | | | | | | | | | | | | 7 | | | | | | 7 |
| | D | Epoxy compound | | 7 | 7 | 7 | 7 | 7 | 7 | 7 | 7 | 7 | 7 | 7 | 7 | 7 | 7 | 7 | 7 | 7 | 7 | 7 | 7 | 7 |
| | E | Titanium dioxide (chlorine method) | | 50 | 50 | 50 | 50 | 50 | 50 | 50 | 50 | 50 | 50 | 50 | 50 | 50 | 50 | 50 | | 50 | 50 | 50 | 50 | 50 |
| | | Titanium dioxide (sulfuric acid method) | | | | | | | | | | | | | | | | | 50 | | | | | |
| | F | Melamine | | 2 | 2 | 2 | 2 | 2 | 2 | 2 | 2 | 2 | 2 | 2 | 2 | 2 | 2 | 2 | 2 | 2 | 2 | 2 | 2 | 2 |
| | | Silicone | | 2 | 2 | 2 | 2 | 2 | 2 | 2 | 2 | 2 | 2 | 2 | 2 | 2 | 2 | 2 | 2 | 2 | 2 | 2 | 2 | 2 |

**[Table 2B]**

| | | Examples | | | | | | | | | | | | | | | | Comparative examples | | | | |
|---|---|---|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 1 | 2 | 3 | 4 | 5 |
| Evaluation | Acid resistance | A | A | A | A | A | A | A | A | A | A | A | A | A | A | A | A | B | *NG* | A | *NG* | A |
| | Alkali resistance | A | A | A | A | A | A | A | A | A | A | A | A | A | A | A | A | A | *NG* | A | *NG* | A |
| | Adhesion | A | A | A | A | A | A | A | A | A | A | A | A | A | A | A | A | A | C | A | C | A |
| | PCT property | A | A | A | A | A | A | A | A | A | A | A | A | A | A | A | A | A | *NG* | B | *NG* | B |
| | Crack resistance | A | A | A | A | A | A | A | A | A | A | A | A | A | A | A | A | B | *NG* | A | *NG* | A |
| | Solder heat resistance | A | A | A | A | A | A | A | A | A | A | A | A | A | A | A | A | B | *NG* | B | *NG* | B |
| | Pencil hardness | 5H | 5H | 5H | 5H | 5H | 5H | 5H | 5H | 4H | 5H | 5H | 5H | 5H | 5H | 5H | 5H | 6H | 5H | 4H | 5H | 5H |
| | Discoloration resistance due to ultraviolet rays (Δb* value) | A | A | A | A | A | A | A | A | A | A | A | A | A | A | A | A | B | A | B | A | B |
| | Discoloration resistance due to heat (Δb* value) | A | A | A | A | A | A | A | A | A | A | A | A | A | A | A | A | A | A | B | A | B |
| | Reflectivity | 83 | 83 | 83 | 84 | 83 | 83 | 82 | 83 | 82 | 83 | 84 | 83 | 83 | 83 | 83 | 81 | 83 | 85 | 83 | 85 | 83 |

| | | | | | | | | | | | | | | | | | | | | | | |
|---|---|---|---|---|---|---|---|---|---|---|---|---|---|---|---|---|---|---|---|---|---|---|
| (Note) "*NG*" means that evaluation test was not carried out due to development defect. | | | | | | | | | | | | | | | | | | | | | | |

## Claims

1. A liquid solder resist composition comprising:
a carboxyl group-containing resin;
a photopolymerizable compound which contains one or more kinds of compounds selected from a group consisting of a photopolymerizable monomer and a photopolymerizable prepolymer;
a photopolymerization initiator;
an epoxy compound; and
titanium dioxide,
the carboxyl group-containing resin being obtained by polymerization of a monomer composition which contains:
a carboxyl group-containing monomer represented by following formula (1); and
a maleimide compound represented by following formula (2),
the carboxyl group-containing resin not containing a photopolymerizable functional group, 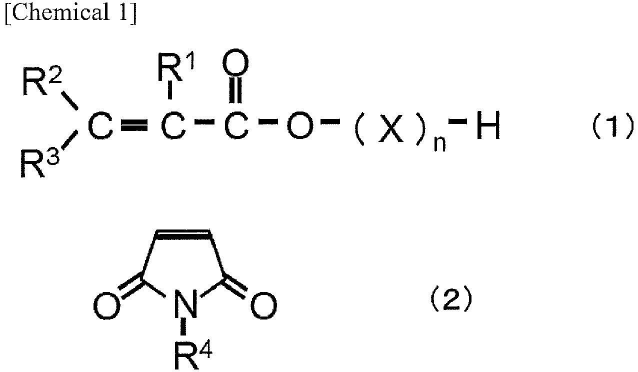
in the formula (1), R¹ representing a hydrogen atom or an alkyl group, R² representing a hydrogen atom, an alkyl group, or an aryl group, R³ representing a hydrogen atom, an alkyl group, or an aryl group, X representing R^{a}-COO, n representing a number which is 0 or larger, and R^{a} in the X representing an organic group, and
in the formula (2), R⁴ representing an organic group.

2. The liquid solder resist composition according to claim 1 wherein
the monomer composition contains 1 to 30 weight% of the maleimide compound with respect to a total monomer content of the monomer composition.

3. The liquid solder resist composition according to claim 1 or 2, wherein
the maleimide compound contains one or more kinds of compounds selected from a group consisting of N-phenyl maleimide, N-benzyl maleimide, and cyclohexyl maleimide.

4. The liquid solder resist composition according to any one of claims 1 to 3 wherein
the carboxyl group-containing monomer contains one or more kinds of compounds selected from a group consisting of methacrylic acid, acrylic acid, ω-carboxy-polycaprolactone monomethacrylate, and ω-carboxy-polycaprolactone monoacrylate.

5. The liquid solder resist composition according to any one of claims 1 to 4, wherein
the monomer composition contains a monomer, other than the carboxyl group-containing monomer and the maleimide compound.

6. The liquid solder resist composition according to any one of claims 1 to 5, wherein
the photopolymerization initiator contains an acylphosphine oxide-based photopolymerization initiator and an α-hydroxy alkylphenone-based photopolymerization initiator.

7. The liquid solder resist composition according to claim 6 wherein
the α-hydroxy alkylphenone-based photopolymerization initiator contains an α-hydroxy alkylphenone-based photopolymerization initiator which is in a form of liquid at 25 °C and an α-hydroxy alkylphenone-based photopolymerization initiator which is in a form of solid at 25 °C.

8. The liquid solder resist composition according to any one of claims 1 to 7, wherein
the carboxyl group-containing resin has an acid value within a range of 100 to 150 mgKOH/g.

9. The liquid solder resist composition according to any one of claims 1 to 8, wherein the titanium dioxide contains rutile titanium dioxide.

10. A covered-printed wiring board, comprising:
a printed wiring board; and
a solder resist layer covering the printed wiring board,
the solder resist layer being formed with the liquid solder resist composition according to any one of claims 1 to 9.

## Patentansprüche

1. Flüssige Lötstopplackzusammensetzung, umfassend:
ein carboxylgruppenhaltiges Harz;
eine photopolymerisierbare Verbindung, die eine oder mehrere Arten von Verbindungen enthält, ausgewählt aus einer Gruppe, bestehend aus einem photopolymerisierbaren Monomer und einem photopolymerisierbaren Prepolymer;
einen Photopolymerisationsinitiator;
eine Epoxidverbindung; und
Titandioxid,
wobei das carboxylgruppenhaltige Harz durch Polymerisation einer Monomerzusammensetzung erhalten wird, die enthält:
ein carboxylgruppenhaltiges Monomer, dargestellt durch die folgende Formel (1); und
eine Maleimidverbindung, dargestellt durch die folgende Formel (2),
wobei das carboxylgruppenhaltige Harz keine photopolymerisierbare funktionelle Gruppe enthält, 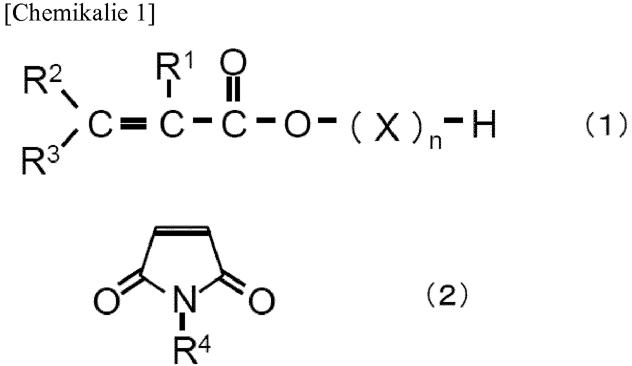
wobei, in der Formel (1), R¹ ein Wasserstoffatom oder eine Alkylgruppe darstellt, R² ein Wasserstoffatom, eine Alkylgruppe oder eine Arylgruppe darstellt, R³ ein Wasserstoffatom, eine Alkylgruppe oder eine Arylgruppe darstellt, X R^{a}-COO darstellt, n eine Zahl darstellt, die 0 oder größer ist, und R^{a} in dem X eine organische Gruppe darstellt, und
wobei, in der Formel (2), R⁴ eine organische Gruppe darstellt.

2. Flüssige Lötstopplackzusammensetzung nach Anspruch 1, wobei
die Monomerzusammensetzung, in Bezug auf einen Gesamtmonomergehalt der Monomerzusammensetzung, 1 bis 30 Gew.-% von der Maleimidverbindung enthält.

3. Flüssige Lötstopplackzusammensetzung nach Anspruch 1 oder 2, wobei
die Maleimidverbindung eine oder mehrere Arten von Verbindungen enthält, ausgewählt aus einer Gruppe, bestehend aus N-Phenylmaleimid, N-Benzylmaleimid und Cyclohexylmaleimid.

4. Flüssige Lötstopplackzusammensetzung nach einem der Ansprüche 1 bis 3, wobei
das carboxylgruppenhaltige Monomer eine oder mehrere Arten von Verbindungen enthält, ausgewählt aus einer Gruppe, bestehend aus Methacrylsäure, Acrylsäure, ω-Carboxypolycaprolactonmonomethacrylat und ω-Carboxypolycaprolactonmonoacrylat.

5. Flüssige Lötstopplackzusammensetzung nach einem der Ansprüche 1 bis 4, wobei
die Monomerzusammensetzung ein Monomer außer dem carboxylgruppenhaltigen Monomer und der Maleimidverbindung enthält.

6. Flüssige Lötstopplackzusammensetzung nach einem der Ansprüche 1 bis 5, wobei
der Photopolymerisationsinitiator einen Acylphosphinoxid-basierten Photopolymerisationsinitiator und einen α-Hydroxyalkylphenon-basierten Photopolymerisationsinitiator enthält.

7. Flüssige Lötstopplackzusammensetzung nach Anspruch 6, wobei der α-Hydroxyalkylphenon-basierte Photopolymerisationsinitiator einen α-Hydroxyalkylphenon-basierten Photopolymerisationsinitiator, der bei 25 °C in einer Form einer Flüssigkeit ist, und einen α-Hydroxyalkylphenon-basierten Photopolymerisationsinitiator enthält, der bei 25 °C in einer Form eines Feststoffs ist.

8. Flüssige Lötstopplackzusammensetzung nach einem der Ansprüche 1 bis 7, wobei
das carboxylgruppenhaltige Harz einen Säurewert in einem Bereich von 100 bis 150 mgKOH/g hat.

9. Flüssige Lötstopplackzusammensetzung nach einem der Ansprüche 1 bis 8, wobei das Titandioxid Rutil-Titandioxid enthält.

10. Bedeckte gedruckte Leiterplatte, umfassend:
eine gedruckte Leiterplatte; und
eine Lötstopplackschicht, die die gedruckte Leiterplatte bedeckt,
wobei die Lötstopplackschicht mit der flüssigen Lötstopplackzusammensetzung nach einem der Ansprüche 1 bis 9 gebildet ist.

## Revendications

1. Composition de réserve de soudure liquide comprenant :
une résine contenant un groupe carboxyle ;
un composé photopolymérisable qui contient un ou plusieurs types de composés sélectionnés dans un groupe constitué d'un monomère photopolymérisable et d'un prépolymère photopolymérisable ;
un initiateur de photopolymérisation ;
un composé d'époxy ; et
un dioxyde de titane,
la résine contenant un groupe carboxyle étant obtenue par la polymérisation d'une composition de monomères qui contient :
un monomère contenant un groupe carboxyle représenté par la formule (1) suivante ; et
un composé de maléimide représenté par la formule (2) suivante,
la résine contenant un groupe carboxyle ne contenant pas un groupe fonctionnel photopolymérisable, 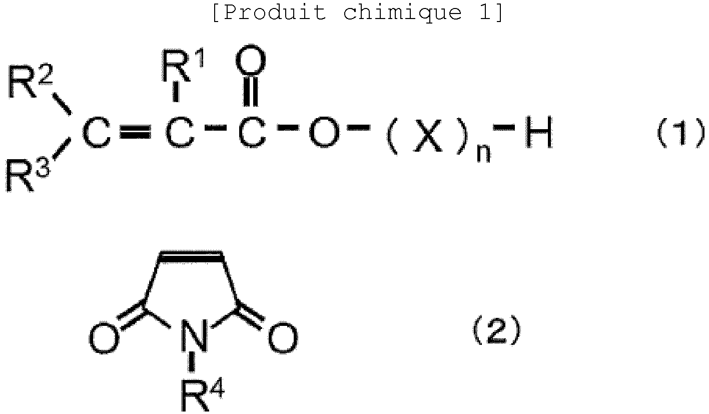
dans la formule (1), R¹ représente un atome d'hydrogène ou un groupe alkyle, R² représente un atome d'hydrogène, un groupe alkyle, ou un groupe aryle, R³ représente un atome d'hydrogène, un groupe alkyle, ou un groupe aryle, X représente R^{a}-COO, n représente un nombre qui est supérieur ou égal à 0, et R^{a} dans le X représente un groupe organique, et
dans la formule (2), R⁴ représente un groupe organique.

2. Composition de réserve de soudure liquide selon la revendication 1 dans laquelle
la composition de monomères contient 1 % à 30 % en poids du composé de maléimide par rapport à une teneur totale en monomères de la composition de monomères.

3. Composition de réserve de soudure liquide selon la revendication 1 ou 2, dans laquelle
le composé de maléimide contient un ou plusieurs types de composés sélectionnés dans un groupe constitué du N-phényl maléimide, du N-benzyl maléimide, et du cyclohexyl maléimide.

4. Composition de réserve de soudure liquide selon l'une quelconque des revendications 1 à 3 dans laquelle
le monomère contenant un groupe carboxyle contient un ou plusieurs types de composés sélectionnés dans un groupe constitué de l'acide méthacrylique, de l'acide acrylique, d'un ω-carboxy-polycaprolactone mono-méthacrylate, et d'un ω-carboxy-polycaprolactone mono-acrylate.

5. Composition de réserve de soudure liquide selon l'une quelconque des revendications 1 à 4 dans laquelle
la composition de monomères contient un monomère, autre que le monomère contenant un groupe carboxyle et le composé de maléimide.

6. Composition de réserve de soudure liquide selon l'une quelconque des revendications 1 à 5 dans laquelle
l'initiateur de photopolymérisation contient un initiateur de photopolymérisation à base d'oxyde d'acylphosphine et un initiateur de photopolymérisation à base d'α-hydroxy alkylphénone.

7. Composition de réserve de soudure liquide selon la revendication 6 dans laquelle
l'initiateur de photopolymérisation à base d'α-hydroxy alkylphénone contient un initiateur de photopolymérisation à base d'α-hydroxy alkylphénone qui est sous la forme d'un liquide à 25 °C et un initiateur de photopolymérisation à base d'α-hydroxy alkylphénone qui est sous la forme d'un solide à 25 °C.

8. Composition de réserve de soudure liquide selon l'une quelconque des revendications 1 à 7 dans laquelle
la résine contenant un groupe carboxyle présente un indice d'acidité situé dans une plage allant de 100 à 150 mg de KOH/g.

9. Composition de réserve de soudure liquide selon l'une quelconque des revendications 1 à 8 dans laquelle
le dioxyde de titane contient un dioxyde de titane rutile.

10. Carte de circuit imprimé recouverte, comprenant :
une carte de circuit imprimé ; et
une couche de réserve de soudure recouvrant la carte de circuit imprimé,
la couche de réserve de soudure étant formée avec la composition de réserve de soudure liquide selon l'une quelconque des revendications 1 à 9.
